# EUROPEAN PATENT APPLICATION

(11) **EP 4 810 651 A1**
(43) Date of publication of application: **23.09.2026**
(21) Application number: 24891346.9
(22) Date of filing: 08.11.2024
(51) Int. Cl.: C23C 14/34, C23C 14/14

(54) **SPUTTERING TARGET ASSEMBLY AND FILM**

(30) Priority: 14.11.2023 JP 2023193867
(71) Applicant: JX Advanced Metals Corporation, Tokyo 105-8417 (JP)
(72) Inventor: MORIOKA, Akira, Kitaibaraki-shi, Ibaraki 319-1535 (JP); NISHIMURA, Kosuke, Kitaibaraki-shi, Ibaraki 319-1535 (JP); DASAI, Takafumi, Kitaibaraki-shi, Ibaraki 319-1535 (JP)
(74) Representative: Mewburn Ellis LLP
(86) International application number: PCT/JP2024/039840
(87) International publication number: WO 2025/105310

(57) **Abstract**

An object of the present disclosure is to provide a tungsten sputtering target assembly in which a target with low flexural strength is used. In one aspect, the present disclosure provides the following invention:
A sputtering target assembly comprising a target, a backing plate, and an insert,
wherein the target consists of W;
the backing plate comprises Ti or a Ti alloy;
the insert comprises Cu or a Cu alloy; and
a flexural strength of the target is 350 MPa or less.

## Description

### [Technical Field]

The present disclosure relates to a sputtering target assembly and a film. Specifically, the present disclosure relates to a tungsten sputtering target assembly and a film manufactured using the same.

### [Background]

In recent years, low electrical resistivity has been required for electrode materials and wiring materials. Tungsten has attracted attention as a material capable of meeting these requirements.

Patent document 1 discloses a tungsten sputtering target capable of forming a tungsten film with low resistivity. Specifically, Patent document 1 discloses a tungsten sputtering target having an average grain size exceeding 100 micrometers to obtain a tungsten film with low resistivity.

Patent document 2 discloses a sputtering target assembly. In this sputtering target assembly, the target and the backing plate are joined via an insert. Furthermore, it is disclosed that metals such as W, Mo, Ti, Ta, Zr, Nb, Al, Ti, and alloys thereof can be used as the target material. Furthermore, it is disclosed that Al, Ag, Cu, Ni, or alloys thereof, etc., can be used as the insert. It is also disclosed that Al and Al alloys, OFC (oxygen-free copper), Cu alloys, Ti, Ti alloys, SUS (stainless steel), etc., can be used as the backing plate.

### [Prior Art]

### [Patent Documents]

[Patent Document 1] Japanese Patent Application Publication No. 2019-090071
[Patent Document 2] Japanese Patent Application Publication No. 2000-239837

### [Summary of the Invention]

### [Problems to be Solved by the Invention]

One of the technical challenges in the process of manufacturing a sputtering target assembly is that a target is susceptible to breakage during the process of manufacturing the sputtering target assembly using a brittle target. This problem is more pronounced when employing a target with low flexural strength.

Accordingly, the present disclosure aims to provide a tungsten sputtering target assembly in which a target with low flexural strength is used.

### [Means for Solving the Problem]

To achieve the above objective, the present disclosure, in one aspect, encompasses the following inventions.

### (Invention 1)

A sputtering target assembly comprising a target, a backing plate, and an insert,
wherein the target consists of W;
the backing plate comprises Ti or a Ti alloy;
the insert comprises Cu or a Cu alloy; and
a flexural strength of the target is 350 MPa or less.

### (Invention 2)

A sputtering target assembly according to Invention 1, wherein an average grain size of the target is 100 micrometers or more.

### (Invention 3)

A sputtering target assembly according to Invention 1 or 2, wherein the target has no crack.

### (Invention 4)

A sputtering target assembly according to any one of Inventions 1 to 3, wherein a shape of the target is circular, and a minimum peel strength is 6 kgf/mm² or more, which is measured at four points on a peripheral region of the target and the backing plate.

### (Invention 5)

A sputtering target assembly according to Invention 4, wherein an average peel strength is 6 kgf/mm² or more, which is measured at 10 points across an entire region of the target and the backing plate.

### (Invention 6)

A sputtering target assembly according to any one of Inventions 1 to 5, wherein there are no surface irregularities on a bonding surface of the target.

### (Invention 7)

A sputtering target assembly according to any one of Inventions 1 to 6, wherein the insert consists of Cu and unavoidable impurities, and the purity of the Cu is 99.9% by mass or higher.

### (Invention 8)

A sputtering target assembly according to any one of Inventions 1 to 7, wherein the insert consists of Cu and unavoidable impurities, and an oxygen content is 10 ppm by mass or less.

### (Invention 9)

A film manufactured using a sputtering target assembly according to any one of Inventions 1 to 8.

### [Effect of the Invention]

In one aspect, the present invention provides an insert comprising Cu or a Cu alloy. This allows for bonding a target with low flexural strength to a backing plate to produce a sputtering target assembly without causing cracks.

### [Brief Description of the Drawings]

[Fig. 1] Fig. 1 illustrates the peel strength measurement locations in a sputtering target assembly according to one embodiment.
[Fig. 2] Fig. 2 illustrates the peel strength measurement locations in a sputtering target assembly according to one embodiment.
[Fig. 3] Fig. 3 illustrates the peel strength measurement locations in a sputtering target assembly according to one embodiment.
[Fig. 4] Fig. 4 illustrates the peel strength measurement locations in a sputtering target assembly according to one embodiment.
[Fig. 5] Fig. 5 illustrates the peel strength measurement locations in a sputtering target assembly according to one embodiment.
[Fig. 6] Fig. 6 illustrates the peel strength measurement locations in a sputtering target assembly according to one embodiment.
[Fig. 7] Fig. 7 illustrates the peel strength measurement locations in a sputtering target assembly according to one embodiment.
[Fig. 8] Fig. 8 illustrates the peel strength measurement locations in a sputtering target assembly according to one embodiment.
[Fig. 9] Fig. 9 illustrates the peel strength measurement locations in a sputtering target assembly according to one embodiment.

### [Embodiments for Implementing the Invention]

The following describes specific embodiments for carrying out the invention. The following description is intended to facilitate understanding of the invention. That is, it is not intended to limit the scope of the present invention.

### 1. Sputtering Target Assembly

In one embodiment, the present disclosure relates to a sputtering target assembly. The sputtering target assembly comprises, at least, a target, a backing plate, and an insert.

### 1-1. Target

### (Shape)

The shape of the target is not particularly limited, but is typically flat. Preferably, the shape of the target as viewed in plan view is either a rectangle (for example, a square, a rectangle, etc.) or a circle, and more preferably, a circle.

### (Composition)

The target consists of tungsten (W).

### (Impurities)

However, the target may contain unavoidable impurities in addition to tungsten. The types of unavoidable impurities are not particularly limited, but may include one or more selected from the group consisting of, for example, carbon and oxygen. The upper limit of the amount of unavoidable impurities is not particularly limited, but may, for example, be 50 ppm by mass or less; preferably, 30 ppm by mass or less; more preferably, 20 ppm by mass or less; and most preferably, 10 ppm by mass or less. Preferably, the amount of oxygen among the unavoidable impurities may be 10 ppm by mass or less. The lower limit of the amount of unavoidable impurities is not particularly limited, but may, for example, be 0 ppm by mass or more, and typically may be 1 ppm by mass or more.

By suppressing the amount of unavoidable impurities (particularly carbon and oxygen), the effect of impurities on the specific resistance of the tungsten film is reduced.

The method for measuring unavoidable impurities is not particularly limited, and known methods practiced in the art may be employed. For example, the carbon concentration may be measured by preparing a sample from the target or from a material of the same origin as the target (e.g., cropped material), and applying the inert gas fusion method to the sample using a carbon analyzer [LECO, CSLS600]. For example, the oxygen concentration may be measured by preparing a sample from the target or a material of the same origin as the target (e.g., cropped material), and applying the inert gas fusion method to the sample using an oxygen-nitrogen simultaneous analyzer [LECO, TC-600].

### (Purity)

As described above, the target consists of tungsten. The purity of the target is not particularly limited, but may be 99.999% by mass (5N) or higher, and preferably 99.9999% by mass (6N) or higher. Increasing the purity enables the formation of a tungsten film with low resistivity.

### (Surface Topography)

When the target is flat, it has two surfaces. The first surface is the side to be sputtered, and the second surface is the bonding surface, i.e., the side facing the backing plate. The surface profile of the second surface is not particularly limited.

In a preferred embodiment, the second surface has no surface irregularities. In this specification, the term "no surface irregularities" means that there are no depressions, and/or, even if depressions exist, the depth of the depressions is less than 0.05 mm. The value of the depth of the depressions may be, for example, a value measured by a depth gauge. Furthermore, the location for measuring the depth is not particularly limited; for example, a straight line of a specific length (e.g., 5 cm) may be drawn at any point on the surface, and the depressions observed along that line may be measured. If multiple depressions exist along the line, the average value of their respective depths may be calculated.

### (Relative Density)

The relative density of the target is not particularly limited, but may, for example, be 99.2% or higher. The reason for this is that the amount of gas components contained in the target is reduced, thereby suppressing the specific resistance of the film when it is formed. A further reason is that dust generation due to abnormal discharge is also suppressed. The relative density of the target is preferably 99.5% or higher, more preferably 99.7% or higher, and even more preferably 99.9% or higher.

The relative density described in this specification refers to the ratio of the measured density to the theoretical density. The measured density refers to the value obtained by the Archimedes method using pure water as the solvent. The theoretical density refers to the theoretical density when the tungsten content is 100%.

### (Flexural strength)

In one embodiment, the target used in the sputtering target assembly of the present disclosure is relatively brittle. Specifically, the flexural strength of the target may be 350 MPa or less. Preferably, the flexural strength of the target may be 300 MPa or less. Although the lower limit is not particularly limited, the flexural strength of the target may be, for example, 250 MPa or more.

Here, the flexural strength can be measured in accordance with JIS R 1601. In the JIS standard, the thickness of a sample is set to 3 mm. For the purpose of processing to such thickness, the front surface and the back surface of the target are ground by the same amount. Then, a sample is cut out from an arbitrary part so as to have a rectangular size of 4 x 40 mm. Specifically, the measurement conditions are as follows.

### (Measurement Conditions for flexural strength)

Test method: 3-point bending test
Distance between supports: 30 mm
Sample size: 3 x 4 x 40 mm
Radius of curvature of support: 5 mm
Head speed: 0.5 mm/min

### (Average grain size)

As described above, the target consists of tungsten. Here, the average grain size of the tungsten crystals is 100 micrometers or more. By ensuring that the average grain size is at or above a predetermined value, the specific resistance can be sufficiently low when the film is formed. Since in the semiconductor field a remarkably low specific resistance is sometimes required, the lower limit of the average grain size of the tungsten crystals may preferably be 110 micrometers or more, more preferably 130 micrometers or more. The upper limit of the average grain size is not particularly limited, but may, for example, be 300 micrometers or less.

In this specification, the average grain size of the tungsten crystals refers to the value measured based on the cutting method specified in JIS G 0551:2013. Specifically, the average grain size of the tungsten crystals refers to the value determined by the following procedure:
- Etching the target surface using a 0.5 mol/L sodium hydroxide solution.
- Observing the microstructure of the target surface using an optical microscope and saving the microstructure image data.
- Drawing three parallel straight lines within the microstructure image. The length of each line is not specifically limited, but it is preferable that the line be long enough to include at least 10 crystal grains.
- Using the number of grains (N) present along each line and the total length of the line (L), and calculating L/N. The average of these calculated values is defined as the average grain size for that observation site.

### 1-2. Backing Plate

The backing plate contains Ti or a Ti alloy. In a preferred embodiment, the backing plate consists of Ti or a Ti alloy. When the backing plate contains Ti or consists of Ti, the term "Ti" refers to pure Ti. However, the Ti in the backing plate may contain unavoidable impurities (for example, 2N5 or higher).

Ti and Ti alloys can contribute to crack prevention by reducing warpage during diffusion bonding with the target.

Furthermore, specific examples of Ti alloys include, for example, Ti-6Al-4V. Additionally, the upper limit of the thermal expansion coefficient of the Ti alloy is preferably 11 × 10⁻⁶/°C or less, and more preferably 9 × 10⁻⁶/°C or less. The thermal expansion coefficient of the backing plate containing Ti or a Ti alloy is also preferably within the aforementioned upper limit range.

### 1-3. Insert

The insert is positioned between the target and the backing plate, serving to bond plate materials that are otherwise difficult to be joined by the target and backing plate alone, thereby preventing cracking and other defects. In one embodiment, the insert includes Cu or a Cu alloy. In a preferred embodiment, the insert consists of Cu or a Cu alloy. Cu or a Cu alloy is suitable for promoting the bonding between a target consisting of tungsten and a backing plate containing Ti or a Ti alloy. Furthermore, Cu or a Cu alloy is a metal with a relatively high melting point. Therefore, it is possible to process (for example, press) the target and backing plate at high temperatures when bonding them. Processing at high temperatures increases the peel strength between the target and the backing plate.

Note that the insert containing Cu or a Cu alloy is not particularly limited. For example, the Cu content in the Cu alloy or the Cu content in the insert is preferably 80 % by mass or more, and more preferably 90 % by mass or more. The melting point of the Cu or Cu alloy used in the insert, or the melting point of the insert containing these, is 1000°C to 1200°C. Furthermore, specific examples of Cu alloys include, for example, red brass (e.g., JIS H 3100, C2100, JIS H 3100, C2200, etc.).

Preferably, the insert consists of Cu. However, the insert may contain unavoidable impurities in addition to Cu.

A higher purity of Cu in the insert is preferred. For example, the purity of Cu may be 99.9 % by mass or higher, preferably 99.90 % by mass or higher, more preferably 99.95 % by mass or higher, and most preferably 99.99 % by mass or higher.

Cu includes, for example: tough pitch copper, oxygen-free copper, etc. Among these, oxygen-free copper is preferred. Oxygen-free copper may be, for example, Cu specified by any of JIS H 3100, C1020, or JIS H 3510, C1011 according to the Japanese Industrial Standards. Alternatively, oxygen-free copper may be Cu specified, for example, in the UNS (Unified Numbering System) database as C10100, C10200, or C11000.

Increasing the purity can improve the peel strength between the target and the backing plate. In a particularly preferred embodiment, reducing the oxygen content as an impurity can improve the peel strength between the target and the backing plate. Also, this provides another advantage of reducing a risk of crack when manufacturing a sputtering target assembly using a target with low flexural strength.

When the insert consists of Cu, the upper limit of the oxygen content as an unavoidable impurity may be 100 ppm by mass or less, and preferably 10 ppm by mass or less. The lower limit of the oxygen content is not particularly limited, but may, for example, be 0 ppm or more, and typically may be 1 ppm or more. The oxygen concentration may be measured by applying the inert gas fusion method to the sample prepared from the insert using an oxygen-nitrogen simultaneous analyzer [LECO, TC-600].

### 1-4. Peel Strength of Sputtering Target Assembly

In the sputtering target assembly of one embodiment of the present disclosure, the peel strength between the target and the backing plate is high.

When the target and backing plate are bonded, it is important that the bond strength be high, particularly in the peripheral region. The reasons for this include the fact that the area of the peripheral region is larger than that of the central region, and that high bond strength in the larger-area region contributes significantly to improving the overall bond strength between the target and the backing plate.

From this perspective, the minimum peel strength measured at four points in the peripheral region of the target and backing plate according to one embodiment of the present disclosure may be 6 kgf/mm² or more.

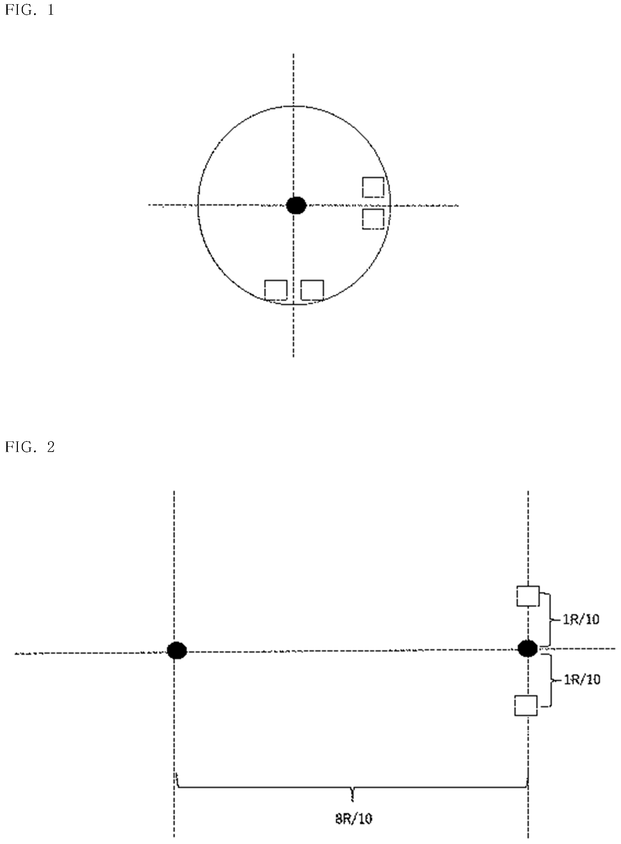

When the target is circular, the four measurement points are identified using the following procedure.
(A) As shown in Figure 1, draw two mutually perpendicular lines passing through the center of the circle (first line, second line).
(B) As shown in Figure 2, on the first line, identify the point where the distance from the center of the circle (the circular symbol in Figure 1) is 8R/10 (where R is the radius).
(C) As shown in Figure 2, draw a perpendicular line from that point to the first line (third line).
(D) As shown in Figure 2, identify two points along the third line, 1R/10 from the point of intersection of the first and third lines (first measurement point, second measurement point).
(E) Perform the same procedure as in (B) through (D) for the second line to identify two points where the distance is 1R/10 (third measurement point, fourth measurement point).

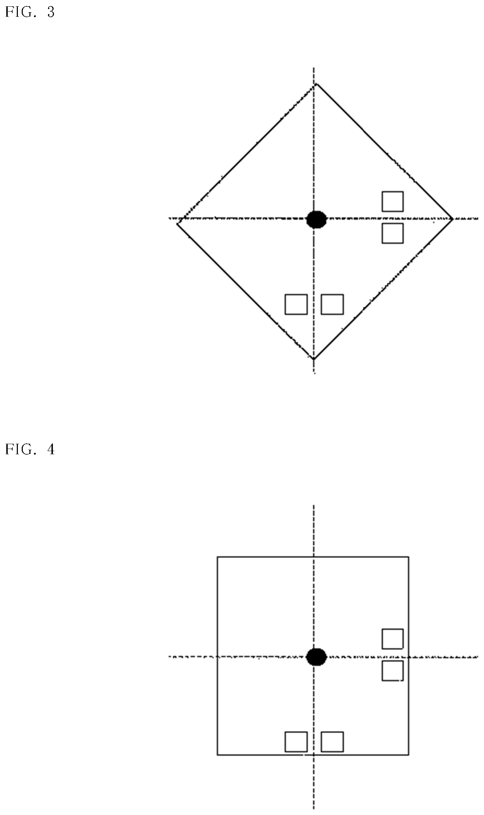

As shown in Figure 3, in the case of a rectangle, the distance from the center to each vertex may be regarded as the radius R of the circular pattern described above, and the procedures (A) through (E) described above may be performed. Alternatively, as shown in Figure 4, in the case of a rectangle, the distance from the center to each side may be regarded as the radius R of the circular pattern described above, and the procedures (A) through (E) described above may be performed. Test specimens may then be collected from these measurement points, tensile tests may be performed on each specimen, and the minimum strength may be adopted.

In one embodiment of the present disclosure, the minimum peel strength measured at four points on the peripheral region between the target and the backing plate may be 6 kgf/mm² or more, as described above, preferably 7 kgf/mm² or more, and more preferably 8 kgf/mm² or more. Although the upper limit is not particularly limited, it may be 10 kgf/mm² or less.

In a further embodiment, when the target and the backing plate are bonded, it is preferable that the bonding strength be high not only in the peripheral region but also throughout the entire region.

In this regard, the average peel strength, measured at 10 points across the entire region of the target and backing plate, may be 6 kgf/mm² or more, preferably 8 kgf/mm² or more, and more preferably 9 kgf/mm² or more. Although there is no specific upper limit, it may be 12 kgf/mm² or less.

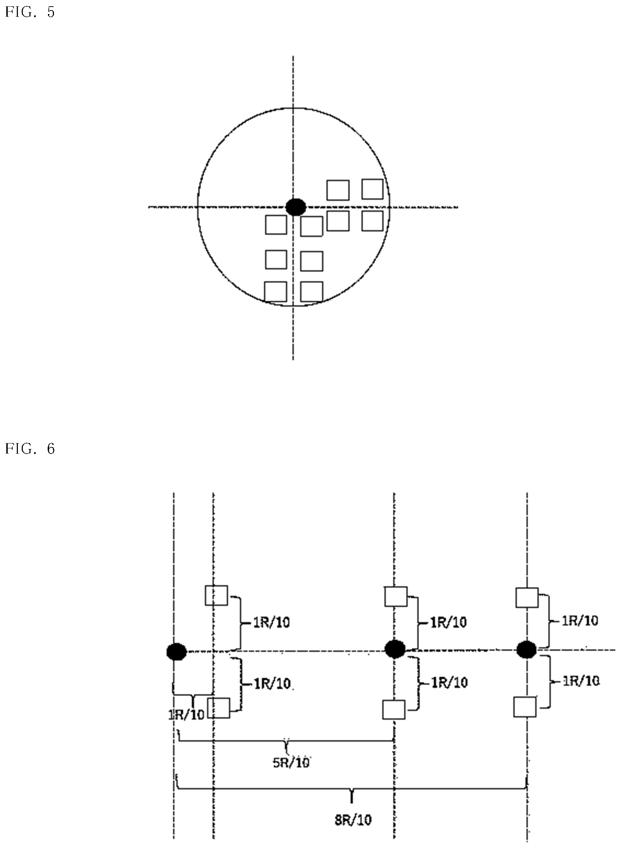

For a circular target, the 10 measurement points are set as follows (see Figures 5 and 6).
(a) Perform the procedure for identifying the four measurement points described above (Measurement Points 1-4).
(b) Perform the procedure for identifying the four measurement points described above (steps A-E), replacing "8R/10" with "5R/10" (Measurement Points 5-8).
(c) Perform the procedure for identifying the two measurement points described above (steps A-D), replacing "8R/10" with "1R/10" (measurement points 9-10).

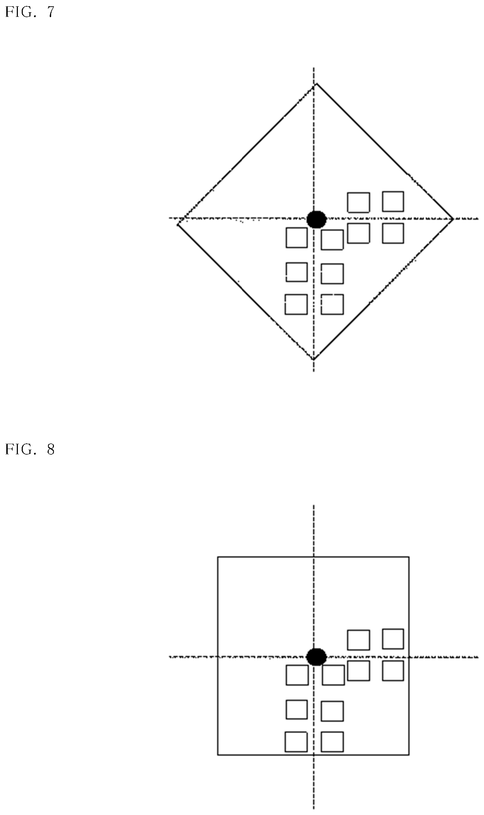

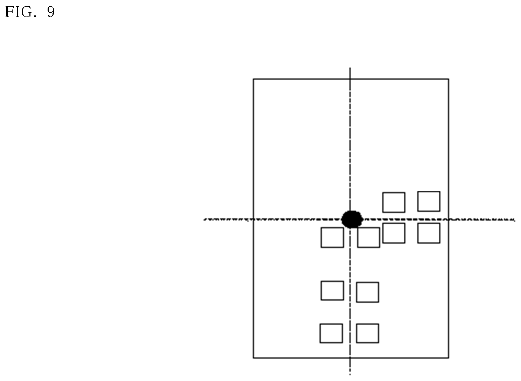

On the other hand, for example, in the case of a rectangle, such as a square, as shown in Figure 7, the distance from the center to a vertex may be regarded as the radius R of the circular pattern described above, and the procedures (a) through (c) described above may be performed. Alternatively, for example, in the case of a rectangle, such as a square, as shown in Figure 8, the distance from the center to each side may be regarded as the radius R of the circular pattern described above, and the procedures (a) to (c) described above may be performed. Test specimens may then be collected from these measurement points, tensile tests may be performed on each specimen, and the average strength may be adopted. Note that when the target is rectangular, step (c) may be performed on either the long side or the short side. Typically, step (c) is performed on the long side (see Figure 9).

The tensile test is performed as follows.
- Prepare a test specimen consisting of a laminate comprising the target, insert, and backing plate, and measure the maximum load (kgf) at which the target and backing plate delaminate. Set the test speed to 0.5 mm/min.
- Divide the measured maximum load by the adhesive area (square millimeters).

Although the equipment for the tensile test is not specifically limited, for example, a φ6 mm tensile test specimen can be prepared, and the peel strength can be measured using the Shimadzu Corporation Precision Universal Testing Machine (Autograph) AG-100kNX plus. Note that the tensile test specimen should include the target, insert, and backing plate in its length, and should be fabricated such that each bonding surface is parallel to the surface of the tensile test specimen.

The target of the present disclosure in one embodiment has the peel strength as described above, and this characteristic is particularly useful when the target has a large grain size (for example, an average grain size of 40 micrometers or more, preferably 100 micrometers or more). While a larger grain size of the target offers the advantage of lower resistance, it tends to reduce the target's strength and increases the likelihood of cracking. One method to reduce cracking is to eliminate stress concentration points. However, a shape without stress concentration points results in a decrease in the bonding strength between the target and the backing plate. The target of the present disclosure in one embodiment contributes to avoiding or compensating for such a decrease in bonding strength.

### 1-5. Cracks of Target in Sputtering Target Assembly

As described above, a target used in a sputtering target assembly according to one embodiment of the present disclosure is relatively brittle. This leads to the possibility of causing cracks when manufacturing a sputtering target assembly (for example, during the application of pressure via HIP treatment).

However, a sputtering target assembly according to one embodiment of the present disclosure is manufactured with an appropriate insert and backing plate (method for manufacturing is described hereinafter), thereby reducing the possibility of causing a crack in the target. Therefore, in one embodiment, a target has no crack. Here, "a target has no crack" means that on the surface of a target (practically, a sputtering side in the target), there is not any crack of which size is big enough (with length of 0.5 cm or more) to be visible with naked eyes.

### 2. Manufacturing Method

In one embodiment, the present disclosure relates to a method for manufacturing the sputtering target assembly described above.

The method may include, for example, the following steps:
- A step of providing a target, an insert, and a backing plate
- A step of stacking the target, insert, and backing plate in that order from the top and HIP (hot isostatic pressing) bonding them

The method may include steps other than those described above. For example, the method may further include a step of performing machining (e.g., cutting, surface processing, surface roughening, etc.) on either the target or the backing plate. For example, the method may further include a process of coating the surface of either the target or the backing plate with a different composition. Alternatively, the method may further include a process of forming a layer consisting of a different composition on the surface of either the target or the backing plate.

### 2-1. Manufacture of the Target

The process of providing the target, insert, and backing plate may include manufacturing the target. The target may be manufactured by melt casting. In this case, further processing such as rolling or cutting may be performed. Alternatively, the target may be manufactured by sintering powder. Preferably, the target is manufactured by powder sintering.

When manufacturing the target by sintering powder, the manufacturing conditions are not particularly limited, and manufacturing conditions known in the art may be adopted.

Preferably, the process may include the following powder sintering steps:
- Performing HP (hot pressing)
- Performing HIP or rolling treatment

First, the HP process involves filling a predetermined mold with tungsten powder as the raw material, applying a load to it, and subjecting it to heat treatment. For the tungsten powder used here, a grain size of 5 micrometers or less is preferred. In the HP process, the temperature is raised at an appropriate heating rate while applying a load suitable for each temperature range to reach the HP temperature, and the temperature is held at the HP temperature for a predetermined time. In this process, a heating rate of approximately 2-10°C/min is preferred. It is also preferable to appropriately adjust and vary the applied load between the temperature range of 600 to less than 1200°C and the range of 1200°C or higher. Since degassing occurs during the initial stage of heating in the HP process, applying high pressure during this stage causes sintering to proceed before sufficient degassing has taken place, resulting in a sintered body that does not achieve high density and contains a large amount of residual gas components such as oxygen. Therefore, in the HP process, applying a lower load in the low-temperature range and a higher load in the high-temperature range increases the density of the sintered body, resulting in a sintered body with a low residual oxygen content. Specifically, it is preferable to apply a load pressure of approximately 80-150 kgf/cm² in the temperature range of 600 to less than 1200°C, and a load pressure of approximately 200-350 kgf/cm² in the temperature range of 1200°C and above. Furthermore, incorporating several holding steps at a constant temperature for a set duration during increasing temperature is effective for obtaining a high-density, randomly oriented sintered body. The HP temperature during this process should preferably be around 1600-1900°C. If the HP temperature is too low, the density will not increase sufficiently; conversely, if it is too high, the formation of a carbonized layer on the tungsten surface will progress, which is undesirable. If the heating rate is too fast, degassing during HP does not proceed sufficiently, which is undesirable. It is clear that if the heating rate is too slow, it leads to reduced productivity, which is also undesirable. The holding time for this process is approximately 30-480 minutes and can be adjusted as appropriate, taking into account conditions such as temperature. The holding time at the HP temperature can be set and adjusted in the same manner. A vacuum atmosphere is preferred for the HP process.

To increase the average grain size of tungsten crystals in HP-processed compacts and to increase the density of the compacts, it is effective to subject the HP compacts to HIP treatment. In one embodiment, the temperature during HIP treatment may be 1600°C or higher, and the treatment time may be 2 hours or longer. Preferably, the temperature during HIP treatment may be 1800°C or higher, and the treatment time may be 5 hours or longer. By setting the HIP treatment conditions to the above-mentioned preferred conditions, a tungsten sputtering target with an average grain size of tungsten crystal exceeding 100 micrometers can be obtained. The pressure during HIP treatment can be adjusted with a target range of 1600-1900 kgf/cm². There is no specific upper limit on the temperature during HIP treatment; however, from a cost perspective, it is preferable to keep it at 2200°C or below. There is no specific upper limit on the duration of HIP treatment; however, from a cost perspective, it is preferable to keep it at 8 hours or less. An inert atmosphere, such as an argon atmosphere, is preferred for the HIP treatment.

### 2-2. Manufacturing of the Sputtering Target Assembly

After manufacturing the target, the target, the insert, and the backing plate are assembled to produce a sputtering target assembly. Specifically, these components can be bonded by stacking them in the order of target, insert, and backing plate from the top and subjecting them to HIP treatment.

Regarding the conditions for the HIP treatment, the HIP treatment pressure can be adjusted with a target range of 1000-2200 kgf/cm², and preferably, the HIP treatment pressure is 1700 kgf/cm² or higher. Furthermore, the temperature may be 400°C or higher, and preferably, 500°C or higher. Although there is no specific upper limit, it is preferable to set the temperature to a level that does not exceed the melting point of at least one of the insert and the backing plate; for example, it may be 800°C or less.

The duration may be 2 hours or more, and preferably 4 hours or more. The upper limit is not particularly limited, but may, for example, be 10 hours or less.

### 3. Applications

The sputtering target assembly described above can be used for the purpose of forming thin films by sputtering. Therefore, in one embodiment, the present disclosure relates to a tungsten film manufactured using the sputtering target assembly described above, and a method for manufacturing the same. Preferably, in one embodiment, the present disclosure relates to a semiconductor having a tungsten film manufactured using the sputtering target assembly described above, and a method for manufacturing the same.

For example, the manufacturing method may include steps such as arranging a substrate and the sputtering target assembly in a chamber so that they face each other, introducing an inert gas (e.g., Ar), and applying a voltage to form a thin film.

The sputtering target assembly in one embodiment of the present disclosure is free from cracks despite employing a target with low flexural strength. Also, the sputtering target assembly in one embodiment of the present disclosure has high peel strength. Therefore, the sputtering target assembly in one embodiment of the present disclosure is advantageous in that it suppresses the occurrence of problems during sputtering.

### [Examples]

Several types of targets consisting of tungsten were prepared. Specifically, multiple targets consisting of tungsten with various average grain sizes (for the grain size measurement method, see "(Average grain size)" in "1-1. Target") were prepared. In Examples 1, 2, and 3, and Comparative Examples 1 and 2, the magnification of the optical microscope was set to 50x, three straight lines were drawn at approximately 1900 micrometers, the L/N ratio was calculated, and the average of the calculated results was rounded to the nearest 5 micrometers increment to determine the average grain size(for example, 130 micrometers for values of 127.5 micrometers or more but less than 132.5 micrometers). In Reference Example 1, three straight lines of approximately 475 micrometers were drawn using an optical microscope at 200x magnification, and L/N was calculated, and the average of the calculated results was rounded to the nearest 5 micrometers increment to determine the average grain size.

The flexural strength was measured via cropped material of the target (for the flexural strength measurement method, see "(Flexural strength)" in "1-1. Target"). Ten cropped materials were sampled from the 1R/2 portion of the target for measurement, and the average value of the maximum stress of these cropped materials is shown in Table 1. Additionally, the arithmetic mean roughness Ra of the offcuts was, for example, 2 to 5.5 micrometers. Note that while the flexural strength was not measured for the sample of Comparative Example 2, it is considered to be on the same level as the flexural strengths of the samples of Examples 1 to 3 and Comparative Example 1."

Regarding the inserts, inserts consisting of Al (Comparative Example 2 and Reference Example 1) and inserts consisting of Cu (Examples 1-3 and Comparative Example 1) were prepared. For the inserts consisting of Cu, oxygen-free copper (JIS H 3100, C1020) and tough-pitch copper (JIS H 3100, C1100) inserts were used.

In Comparative Example 2 and Reference Example 1, to strengthen the bond between the target and the backing plate, a surface irregularities processing was performed on the bonding surface of the target side using the method described in WO 2016/017432.

Regarding the backing plates, we prepared a backing plate consisting of Cu-Zn (Comparative Examples 1-2 and Reference Example 1, 63 wt% Cu, 37 wt% Zn), a backing plate consisting of Ti (Example 1-2), and a backing plate consisting of a Ti alloy (specifically, Ti-6Al-4V) (Example 3).

Based on the combination conditions shown in Table 1, the layers were stacked in the order of target, insert, and backing plate from the top. The stacked assembly was subjected to HIP treatment. The HIP treatment pressure was set to 1800 kgf/cm². The heating rate was set to 100-300 °C/h. The atmosphere was set to argon gas. The temperature and time were set according to the conditions shown in Table 1.

After bonding via HIP treatment, the presence or absence of cracks on the sputtering surface of the target was visually inspected. Then, test specimens were cut from the sputtering target assembly having no cracks at the locations shown in Figure 5. Then, for each test specimen, the sample was pulled at a speed of 0.5 mm/min in a direction perpendicular to the joint surface of the targets, and the peel strength was measured. The measurements were performed using a Shimadzu Corporation Precision Universal Testing Machine (Autograph) AG-100kNX plus.

Table 1 shows the minimum peel strength measured at four points in the peripheral region (see Figures 1 and 2) and the average peel strength measured at ten points across the entire region (see Figures 5 and 6).

**[Table 1]**

| | **Average value of the maximum stress for flexural strength (MPa)** | **W target average grain size (micrometer)** | **Surface irregularities processing** | **Insert** | **Backing Plate** | **HIP Temperature (degree Celsius)** | **HIP duration time (h)** | **Minimum peel strength, which is measured at four points on a peripheral region (kgf/mm²)** | **Average peel strength, which is measured at 10 points across an entire region (kgf/mm²)** |
|---|---|---|---|---|---|---|---|---|---|
| **Example 1** | **279** | **150** | **not performed** | **tough pitch copper** | **Ti** | **525** | **4** | **7.00** | **8.25** |
| **Example 2** | **292** | **130** | **not performed** | **oxygen-free copper** | **Ti** | **525** | **4** | **8.96** | **10.00** |
| **Example 3** | **332** | **135** | **not performed** | **oxygen-free copper** | **Ti-6Al-4V** | **525** | **4** | **7.82** | **6.25** |
| **Comparative Example 1** | **303** | **130** | **not performed** | **oxygen-free copper** | **CuZn** | **525** | **4** | ****** | ****** |
| **Comparative Example 2** | **not measured** | **130** | **performed** | **Al** | **CuZn** | **290** | **1** | ****** | ****** |
| **Reference Example 1** | **580** | **30** | **performed** | **Al** | **CuZn** | **290** | **1** | **5.60** | **5.89** |

| | | | | | | | | | |
|---|---|---|---|---|---|---|---|---|---|
| ** Peel strength was unmeasurable due to crack | | | | | | | | | |

Compared to the sputtering target assembly in which the backing plate consisted of CuZn (Comparative Example 1), the sputtering target assemblies in which the backing plate consisted of Ti or Ti alloy (Examples 1-3) were manufactured without causing cracks. Similarly, compared to the sputtering target assembly in which the insert consisted of Al (Comparative Example 2), the sputtering target assemblies in which the insert consisted of Cu (Examples 1-3) were manufactured without causing cracks. Furthermore, the sputtering target assembly of Examples 1-3 ensured sufficient peel strength in the peripheral region and the entire region. Compared between Reference Example 1 and Examples 1-3, Examples 1-3 achieved peel strength that was higher than that of Reference Example 1 in which peel strength was enhanced by the surface irregularities processing.

0 0 7 6 1 Detailed embodiments of the present invention have been described above. These embodiments are merely specific examples, and the present invention is not limited thereto. For example, technical features disclosed in one of the above embodiments can be applied to other embodiments. Furthermore, unless otherwise specified, regarding a particular method, the order of some steps may be interchanged with other steps, and an additional step may be inserted between any two steps. The scope of the present invention is defined by the claims.

## Claims

1. A sputtering target assembly comprising a target, a backing plate, and an insert,
wherein the target consists of W;
the backing plate comprises Ti or a Ti alloy;
the insert comprises Cu or a Cu alloy; and
a flexural strength of the target is 350 MPa or less.

2. A sputtering target assembly according to claim 1, wherein an average grain size of the target is 100 micrometers or more.

3. A sputtering target assembly according to claim 1 or 2, wherein the target has no crack.

4. A sputtering target assembly according to any one of claims 1 to 3, wherein a shape of the target is circular, and
a minimum peel strength is 6 kgf/mm² or more, which is measured at four points on a peripheral region of the target and the backing plate.

5. A sputtering target assembly according to claim 4, wherein an average peel strength is 6 kgf/mm² or more, which is measured at 10 points across an entire region of the target and the backing plate.

6. A sputtering target assembly according to any one of claims 1 to 5, wherein there are no surface irregularities on a bonding surface of the target.

7. A sputtering target assembly according to any one of claims 1 to 6, wherein the insert consists of Cu and unavoidable impurities, and the purity of the Cu is 99.9% by mass or higher.

8. A sputtering target assembly according to any one of claims 1 to 7, wherein the insert consists of Cu and unavoidable impurities, and an oxygen content is 10 ppm by mass or less.

9. A film manufactured using a sputtering target assembly according to any one of claims 1 to 8.
